# DEMANDE DE BREVET EUROPEEN

(11) **EP 0 895 445 A1**
(43) Date de publication de la demande: **03.02.1999**
(21) Numéro de dépôt: 98500155.1
(22) Date de dépôt: 07.07.1998
(51) Int. Cl.: H05K 1/02, H05K 3/06

(54) **Perfectionnement des conceptions d'inter-pistes sur les circuits imprimés de puissances**

(30) Priorité: 30.07.1997 ES 9701683
(71) Demandeur: MECANISMOS AUXILIARES INDUSTRIALES S.A. M.A.I.S.A., E-43800 Valls, Tarragona (ES)
(72) Inventeur: Llop Tous, Jordi, 43800 Valls (Taragona) (ES)
(74) Mandataire: Morgades Manonelles, Juan Antonio

(57) **Abrégé**

Un circuit imprimé de puissance (10) amélioré est formé à base d'un substrat diélectrique (11) sur lequel est obtenu un ensemble de pistes conductrices (12) en cuivre comme conséquence d'une attaque chimique prévue dans les zones non recouvertes d'une couche de cuivre disposée sur ce substrat diélectrique, caractérisés par le fait que la distance "c" entre les centres des pistes (12) seront de 1,27mm lorsque la distance "d" d'inter-piste entre les points inférieurs des plans (12b) est de 0,5mm et la distance "b" entre les points supérieurs de (12b) est de 0,65mm.

## Description

La présente sollicitude de patente d'invention consiste, conformément aux indications de l'énoncé, en des "PERFECTIONNEMENTS DES CONCEPTIONS D'INTER-PISTES SUR LES CIRCUITS IMPRIMÉS DE PUISSANCE", dont les nouvelles caractéristiques de construction, conformation et conception remplissent la mission pour laquelle il a été spécifiquement projeté, avec un maximum de sécurité et d'efficacité.

L'invention se réfère plus concrètement à une nouvelle conception de l'espace qui se trouve sur les pistes conductrices sur les circuits imprimés dénommés inter-pistes sur lesquelles, suite à l'augmentation de la hauteur des pistes, il faut assurer une isolation entre celles-ci en augmentant la largeur ou la conception de l'inter-piste.

Comme il est notoire, le circuit imprimé se compose de pistes en cuivre sur un substrat diélectrique, obtenues par attaque chimique sur une couche conductrice qui a elle-même été recouverte du masque correspondant.

La conception des pistes, ainsi que l'épaisseur de leur partie conductrice, seront en fonction des nécessités du circuit imprimé, des composants qui sont situés au-dessus et des intensités qui devront les parcourir.

Dans la production actuelle de circuits imprimés de 400 microns d'épaisseur de cuivre, la conception doit assurer une isolation entre les pistes. Ceci détermine que l'inter-piste a une largeur minimum. Dans la conception de circuits d'électronique, c'est-à-dire des parcours de moindre intensité et de moindre puissance, cet aspect est réduit ou minimisé en raison des bas profils d'épaisseur de cuivre.

Dans le processus de fabrication du circuit de puissance, la largeur de l'inter-piste augmentera par rapport au masque conçu.

Comme conséquence de tout ce qui précède, actuellement, lorsque la couche conductrice est de 400 microns, le passage minimum, ou distance entre centres de pistes ou centres de trous, est de 5 mm selon les normes de conception admises dans ce secteur technique.

De cette manière, il n'est pas possible de poser des composants SMD (montage superficiel) d'un passage de 1,27 mm (distance entre les centres des pins).

Si on conçoit un PCB de puissance et qu'on l'attaque d'une façon conventionnelle, les petites zones de cuivre qui abritent les composants superficiels s'en trouveront très affaiblies voire entièrement annulées.

La solution adoptée est celle de réaliser la conception de la zone où sont localisés les composants électroniques avec une inter-piste de 0,15 mm. Les conséquences de tout cela étant les suivantes :

L'inter-piste augmentera jusqu'à un maximum de 0,65 mm en passant de 0,15 mm à 0,65 mm en raison du processus de manufacture du fabricant de circuits.

Ces dimensions permettent de créer une zone de cuivre minimum autour du terminal et donc de le souder.

Tout cela présentera les avantages suivants : Cela permet une plus grande intégration (plus grand nombre de composants) de l'électronique dans des boîtes de services fabriquées par le sollicitant, en ajoutant les composants de la gamme de passage de 1,27 mm en technologie superficielle.

Cela permet la pose de circuits du type FET en format SO. Ces circuits nécessitent des radiateurs pour pouvoir dissiper la puissance en forme de chaleur. En les intégrant sur des circuits de 400 microns, nous en tirerons une meilleure efficacité. Cela est possible car ces circuits possèdent une plus grande capacité thermique.

D'autres détails et caractéristiques seront soulignés au cours de la description qui est donnée ci-dessous et qui fait référence aux figures accompagnant ce mémoire dans lequel, de façon quelque peu schématique, sont représentés les détails préférés. Ces détails sont donnés à titre d'exemple et se réfèrent à un cas possible de réalisation pratique, mais ne demeurent pas limités aux détails et composants qui y sont exposés ; cette description doit donc être considérée d'un point de vue illustratif et sans aucune sorte de limitations.

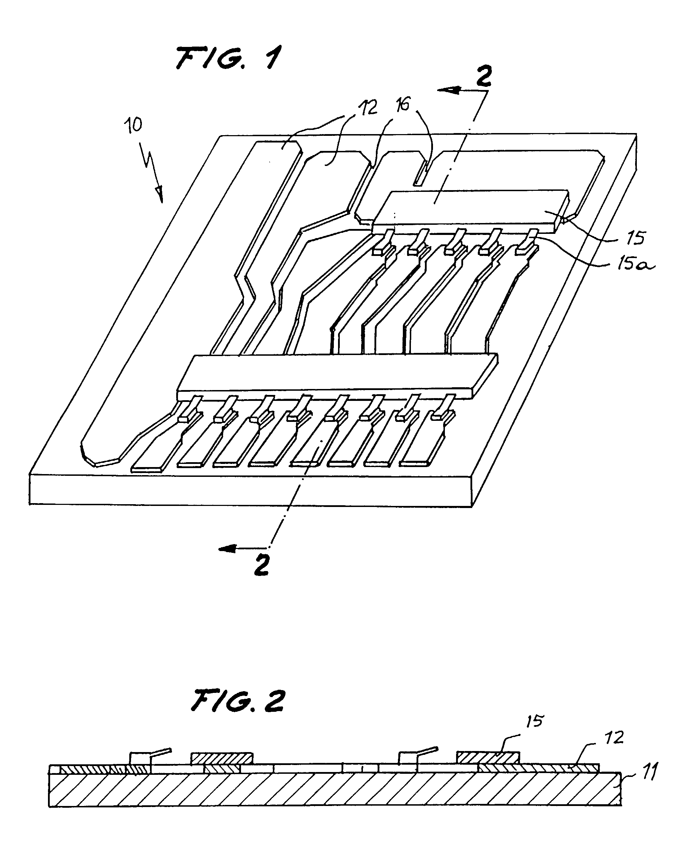

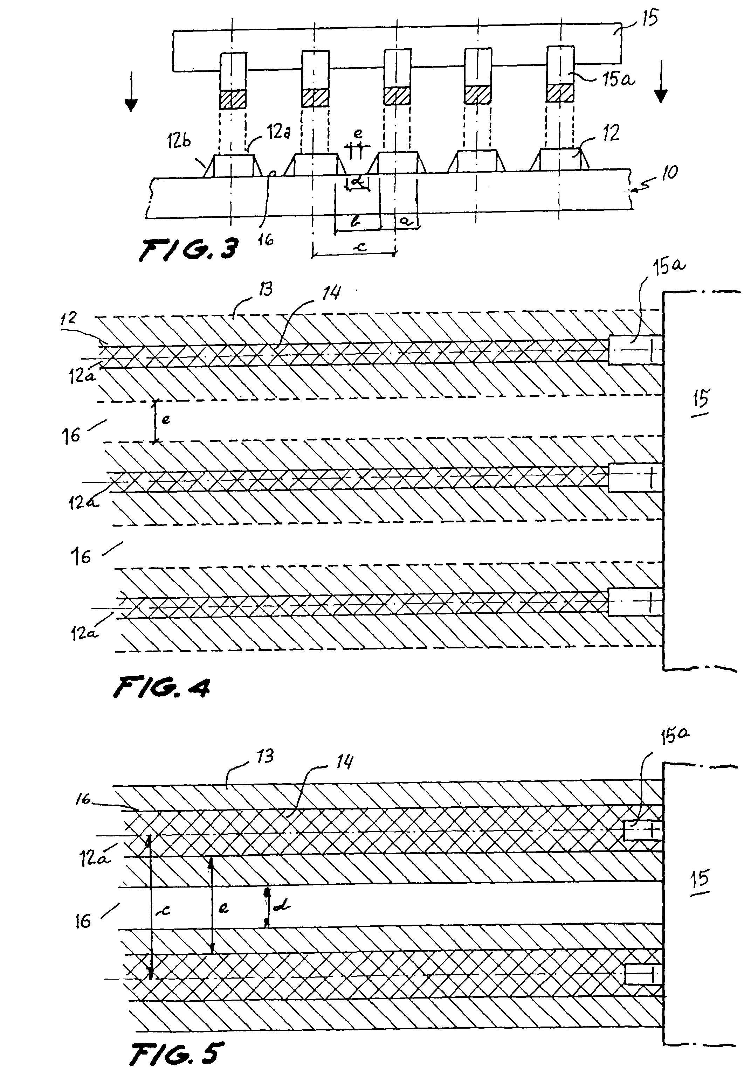

On trouvera ci-dessous une liste détaillée des principaux éléments de l'objet de la présente invention: (10) circuit imprimé, (11) substrat diélectrique, (12) piste conductrice après l'attaque chimique, (12a) surface de piste, (12b) zone latérale de piste, (13) piste théorique de cuivre avant l'attaque chimique, (15) composant électronique SMD, (15a) pins.
La figure nº 1 est une perspective d'un circuit imprimé (10) sur lequel on peut voir des pistes conductrices (12) parmi lesquelles se trouvent les inter-pistes (16) et, soudés et insérés sur celles-ci, les composants (15) au moyen des pins (15a).
La figure nº 2 est une section par 2 - 2 selon figure nº 1
La figure nº 3 est une section transversale en élévation, schématisée, d'un circuit imprimé (10) sur lequel est projetée la largeur des pins (15a) d'un composant (15) sur une piste conductrice (12).
La figure nº 4 est une vue supérieure en section**, schématisée, d'une disposition de pistes (12) et d'inter-pistes (10) avant et après une attaque chimique conventionnelle.
La figure nº 5 est une figure analogue à la figure nº 4 mais avec une conception d'inter-pistes de 0,55 mm. Sur l'une des exécutions possibles de ce qui fait l'objet de la présente sollicitude, comme on peut le voir sur la figure nº 1, un circuit imprimé (10) est formé d'un ensemble de pistes conductrices (12) entre lesquelles se trouvent les inter-pistes (16) disposées sur une base de matériel diélectrique (11). Des composants (15) sont montés sur ces pistes (12), par soudure ou toute autre opération d'insertion similaire.

Comme l'indique la figure nº 4, (13) est la piste de cuivre théorique avant l'attaque chimique, cependant que la même piste de cuivre est signalée par (12a) après l'attaque chimique.

Comme le montre la figure nº 4, avec une conception d'inter-piste de 0,55 mm, on constate que la zone (12a) où devraient être soudés le composant (15) et le pin (15a) est trop petite et, par conséquent il n'est pas possible de souder ce composant. Dans ce cas, après l'attaque chimique, l'inter-piste est de 1,1 mm.

Donc, la solution au problème est celle qui a été conçue sur la figure nº 5, sur laquelle nous pouvons voir comment le passage "c" entre centres de pistes conductrices (12) en cuivre devient de 1,27 mm en laissant une inter-piste "d" de 0,65 mm après l'attaque chimique, ce qui fait que, comme l'indique la figure nº 5, dans la partie horizontale (12a) il est possible de souder les pins (15a) des composants sur les pistes (12) sans aucune sorte de problème.

La solution trouvée et montrée sur la figure nº 5, sur laquelle la distance entre centres de pistes (12) conductrices en cuivre deviennent de 1,27 mm, car il est prévu que les distances entre les points inférieurs des zones (12b) deviennent de 0,15 mm et les distances entre les points supérieurs de (12a) de 0,65 mm après l'attaque chimique.

On évite ainsi les problèmes précédemment énoncés et qui se posent lorsque la hauteur des pistes de cuivre a été augmentée pour pouvoir ainsi, en premier lieu obtenir une meilleure densité de pistes et, d'autre part, pour que celles-ci, c'est-à-dire leur section transversale celle de (12), puissent supporter une plus grande intensité sans que pour autant ne surgissent des problèmes d'isolation sur l'espace "b" des inter-pistes.

La présente sollicitude de patente d'invention ayant été suffisamment décrite en correspondance avec les plans ci-joints, il est entendu que toutes modifications de détail jugées opportunes pourront être introduites sur ceux-ci, à la condition de ne pas altérer l'essence de la patente qui se trouve résumée dans les revendications suivantes.

## Revendications

1. "PERFECTIONNEMENTS DES CONCEPTIONS D'INTER-PISTES SUR LES CIRCUITS IMPRIMÉS DE PUISSANCE" (10) de ceux qui sont formés à base d'un substrat diélectrique (11) sur lequel est obtenu un ensemble de pistes conductrices (12) en cuivre comme conséquence d'une attaque chimique prévue dans les zones non recouvertes d'une couche de cuivre disposée sur ce substrat diélectrique, caractérisés par le fait que la distance "c" entre les centres des pistes (12) seront de 1,27 mm lorsque la distance "d" d'inter-piste entre les points inférieurs des plans (12b) est de 0,5 mm et la distance "b" entre les points supérieurs de (12b) est de 0,65 mm.
